Europäisches Patentamt

European Patent Office

Office européen des brevets

(11) Publication number: **0 130 716**
**A2**

# EUROPEAN PATENT APPLICATION

(21) Application number: **84304003.1**

(22) Date of filing: **14.06.84**

(51) Int. Cl.⁴: **H 03 M 1/18**, H 03 M 1/70

(30) Priority: **29.06.83 JP 115886/83**

(43) Date of publication of application: **09.01.85**
**Bulletin 85/2**

(84) Designated Contracting States: **DE FR GB**

(71) Applicant: **FUJITSU LIMITED, 1015, Kamikodanaka Nakahara-ku, Kawasaki-shi Kanagawa 211 (JP)**

(72) Inventor: **Gotoh, Kunihiko c/o Fujitsu Limited, Patent Department 1015 Kamikodanaka Nakahara-ku, Kawasaki-shi Kanagawa. 211 (JP)**
Inventor: **Itoh, Akihiko c/o Fujitsu Limited, Patent Department 1015 Kamikodanaka Nakahara-ku, Kawasaki-shi Kanagawa. 211 (JP)**
Inventor: **Yamamura, Takeshi c/o Fujitsu Limited, Patent Department 1015 kamikodanaka Nakahara-ku, Kawasaki-shi Kanagawa. 211 (JP)**
Inventor: **Kondo, Hiroshi c/o Fujitsu Limited, Patent Department 1015 Kamikodanaka Nakahara-ku, Kawasaki-shi Kanagawa. 211 (JP)**
Inventor: **Haga, Akira c/o Fujitsu Limited, Patent Department 1015 Kamikodanaka Nakahara-ku, Kawasaki-shi Kanagawa. 211 (JP)**

(74) Representative: **Sunderland, James Harry et al, HASELTINE LAKE & CO Hazlitt House 28 Southampton Buildings Chancery Lane, London WC2A 1AT (GB)**

(54) **Signal processing integrated circuit with AD or DA converter.**

(57) In an IC used for a PCM communication system, for example, a CODEC circuit, the signal level in the circuit is required to be kept exactly to a specific value. In such a circuit, it is very difficult to keep a specific gain of the circuit because of the effects of filters and parasitic capacitances or parasitic resistances of the circuit, and so forth.

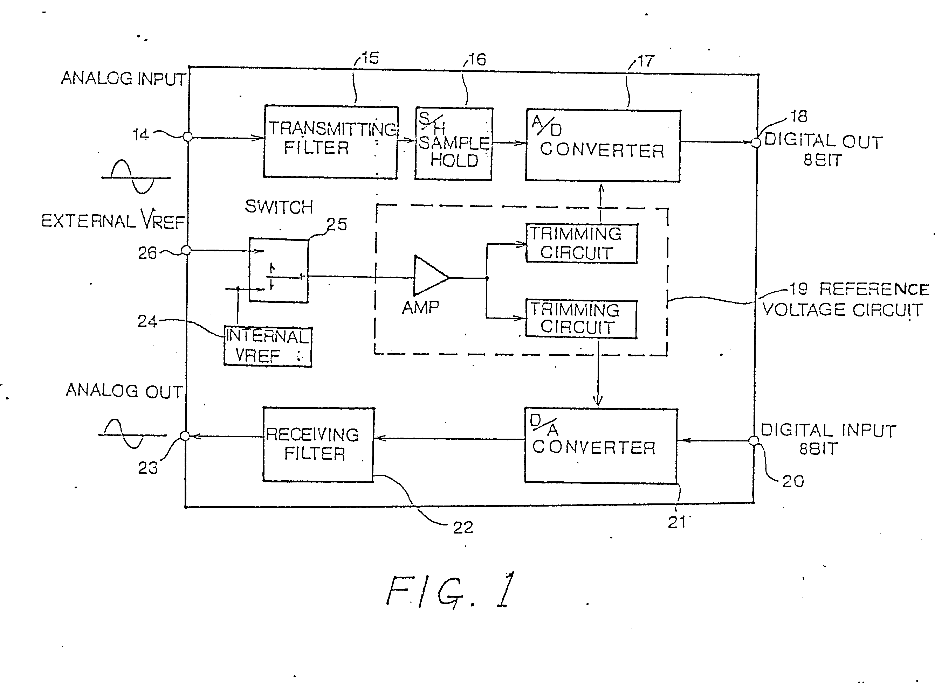

The present invention provides a trimming circuit for the reference voltage of an AD or DA converter, by which the conversion gain of the AD or DA converter, and hence the gain of the CODEC circuit, can be trimmed in steps by blowing built in fuses. The present invention also provides a switched resistor circuit, by which the conversion gain can be switched, allowing processing of signals conforming to different conversion laws. Fig. 1.

0130716

## SIGNAL PROCESSING INTEGRATED CIRCUIT
## WITH AD OR DA CONVERTER

This invention relates to a signal processing integrated circuit including analog to digital (AD) and/or digital to analog (DA) converters.

Digitizing of voice signals for transmission is becoming increasingly popular. The most popular modulation method is pulse code modulation (PCM). Two specific kinds of transfer characteristics for companded (compressed and expanded amplitude) PCM transmission of voice signals have been standardized by the Consultative Committee on International Telephone and Telegraph (CCITT), one is Mu-law, and the other is A-law. In either case, at the transmitting end the voice signal must be converted from analog to digital form, and at the receiving end the digitized voice signal must be converted back to analog form.

An eight bit companded DA converter is normally used to perform Mu-law or A-law pulse code modulation. The A-law system is used in Europe and the Mu-law system is used in the United States and Japan. In general, there are eight chords or segments in Mu-law, and these are expressed in digital form as 00000000 to 11111111.

In a DA converter, for example, it is well known that the output analog signal level is determined arithmetically from the input digital signal and a reference voltage which is used in the DA converter.

The gain of a DA converter can be defined as the ratio of the output analog signal from a DA converter to the input signal which is expected arithmetically from the input digital signal (that is, the analog signal corresponding to the input digital signal).

Similarly the gain of an AD converter can be defined as the ratio of the output (analog) signal arithmetically calculated from the output digital signal of the AD converter, to the input analog signal.

These gains are called the conversion gain of a DA converter or an AD converter respectively.

If the conversion gain of an AD or DA converter varies, the circuitry which includes the AD or DA converter may suffer malfunctions due to the fluctuation of signal levels. In PCM communication systems in particular, signal levels in specific circuitry portions must be kept at specific values.

An integrated circuit (IC) used for such systems, for example a CODEC (coder and decoder) circuit, includes a filter and an (expanding) AD converter (as an encoder) or a filter and a (compressing) DA converter (as a decoder). In such a circuit, it is very difficult to keep the signal levels or the gain constant in specific portions of the circuit, because it is difficult to trim the gain of the circuitry in the IC.

Conventionally, the adjustment of such circuits is done by the method of adjusting individually the input signal level, the characteristics of filters in the circuit or the reference voltage for the AD or DA converter.

In such a circuit, the possible locations for inserting gain control circuitry are limited, and moreover, by inserting such gain control circuitry, the circuit suffers deterioration of frequency response, and so forth. In conventional methods, therefore, the filter and the gain of the AD or DA converter must be adjusted individually, and this is difficult.

In some cases the adjustment is done by trimming the reference voltage, by the method of adjusting an attenuator inserted in a reference voltage circuit. However, by this method, the reference voltage can only be trimmed to a lower voltage than its input value; it is impossible to trim to a higher voltage.

According to the present invention, there is provided a signal processing integrated circuit comprising:

an analog to digital converter (AD converter) and /or a digital to analog converter (DA converter) and

a reference voltage circuit operable to apply a converter reference voltage operatively applied to the AD and/or DA converter, comprising

an amplifier arranged for receiving an input reference voltage, and

an adjusting circuit connected to the amplifier, the amplifier and adjusting circuit being operable to determine together the converter reference voltage, so as to allow adjustable conversion gain of the AD and/or DA converter.

An embodiment of the present invention can provide a circuit including an AD or DA converter whose conversion gain is adjustable.

An embodiment of the present invention can provide a method of adjustment of a reference voltage of an AD or DA converter, which allows adjustment not only to decrease but also to increase the reference voltage.

An embodiment of the present invention can also provide an IC for a CODEC circuit whose conversion gain can be switched for processing signals having different kinds of transfer characteristics, such as transfer characteristics according to A-law or Mu-law.

An embodiment of the present invention can also provide an IC for a CODEC with a trimming circuit to trim the conversion gain.

An embodiment of the present invention provides means for amplifying the reference voltage, and then trimming it to a specific value. The conversion gain of an AD or DA converter, and consequently the gain of the IC, can hence be increased or decreased without affecting other circuit characteristics such as frequency characteristics.

Reference is made, by way of example, to the accompanying drawings in which:-

Fig. 1 is a block diagram of a single-chip CODEC with filters, embodying the present invention;

Fig. 2 is a block diagram illustrating the principle of a trimming circuit for adjusting a reference voltage, applicable to an AD or DA converter according to the present invention;

Fig. 3 shows schematically a typical decoder (DA converter) circuit suitable for connection to the circuit of Fig. 2;

Fig. 4 shows a trimming circuit employed in an embodiment of the present invention;

Fig. 5 is a table illustrating four trimming patterns and the resulting output voltages, for the circuit shown in Fig. 4,

Fig. 6 shows a reference voltage circuit according to an embodiment of the present invention, for an AD or DA converter, which enables adjustment of the gain of the converter, for use with signals having two kinds of transfer characteristics (for example, A-law and Mu-law); and

Fig. 7 shows another reference voltage (gain adjusting) circuit according to an embodiment of the present invention.

Fig. 1 is a block diagram of a single-chip CODEC incorporating filters, as a signal processing integrated circuit (IC) embodying the present invention. The operation of this circuit is as follows.

An analog input signal applied to a terminal 14 is received by a transmitting filter 15. Undesirable frequency components of the input signal are filtered out by this filter, then the signal is sampled at predetermined time intervals by a sample-and-hold circuit 16, and applied to an AD converter 17. The AD converter 17 performs analog to digital conversion according to a Mu-law companding law, for example, using a capacitor array and a resistor string. The converted 8 bit PCM signals are sent out from a digital out terminal 18.

A PCM signal is supplied to a DA converter 21 through a digital input terminal 20. The DA converter 21 converts the digital signal to an analog signal using a capacitor array and a resistor string, for example, and the converted signal is applied to a receiving filter 22. Then the converted analog out signal is sent out through an analog out terminal 23.

A reference voltage circuit 19, shown by a broken line, supplies a reference voltage for the AD converter 17 or DA converter 21. This reference voltage circuit 19 comprises an amplifier for amplifying an external 26 or internal 24 input reference voltage $V_{REF}$ selected by the switch 25, and a trimming circuit for adjusting the output voltage of the amplifier. The output voltage of the trimming circuit is used as a reference voltage for the AD converter 17 or DA converter 21 to fix their conversion gains.

As can be seen it is possible to adjust the conversion gain of a converter by trimming its reference voltage, and this adjusts the overall gain of the IC.

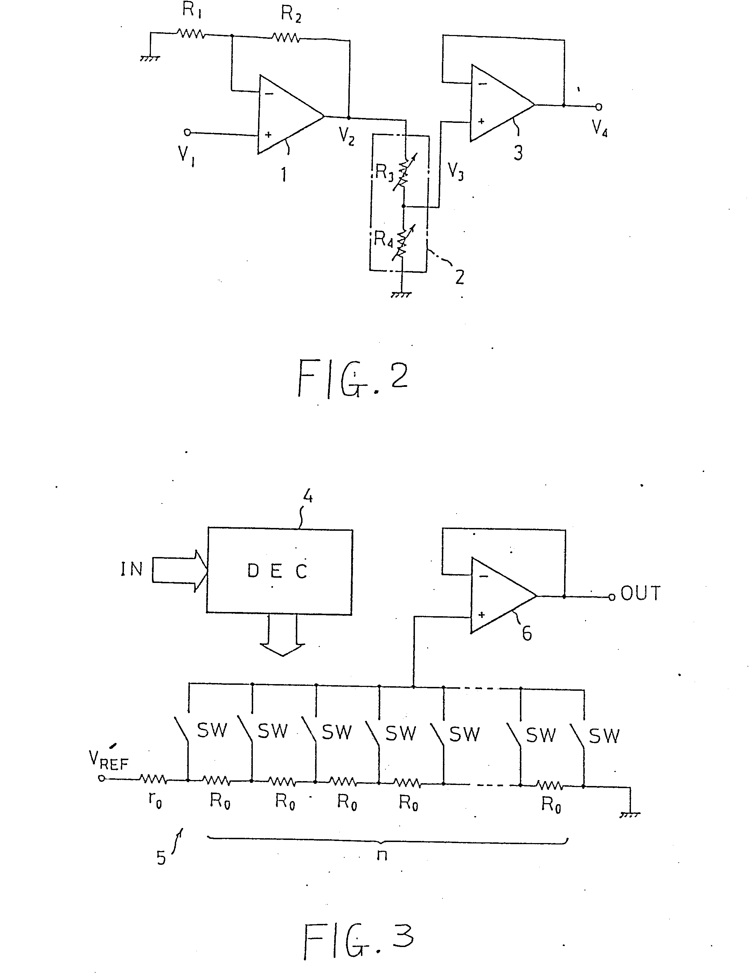

Fig. 2 is a block diagram illustrating the principle of a reference voltage circuit employed in an embodiment of the present invention. In Fig. 2, an amplifier 1 amplifies an input reference voltage $V_1 (V_{REF})$ and provides an output voltage $V_2$. The amplifier 1 is provided with a feedback circuit composed of resistors $R_1$, $R_2$. The characters $R_1$, $R_2$ and so on designate resistors themselves and also their respective resistance values.

The voltage $V_2$ is determined by the ratio of resistance values $R_1$ and $R_2$, and is given as

$$V_2 = (1 + R_2/R_1) \, V_1 \tag{1}$$

The voltage $V_2$ is divided by resistors $R_3$ and $R_4$ of trimming circuit 2, providing an output voltage $V_3$ to

0130716

the buffer amplifier 3. If the output terminal of the amplifier 3 is connected to its input, as shown in Fig. 2, the gain of the buffer amplifier 3 is equal to 1, and its output voltage $V_4$ is equal to the output voltage $V_3$ of the trimming circuit 2. Therefore, the output voltage $V_4$ can be obtained from the following equation:

$$V_4 = (1 + R_2/R_1) \frac{R_4}{R_3 + R_4} V_1 \qquad (2)$$

As can be seen from equations (1) and (2), the output voltage $V_2$ of amplifier 1 can be made greater than the input reference voltage $V_1$, therefore, the output voltage $V_4$ of amplifier 3 may be increased or reduced relative to the input reference voltage. Hence, by virtue of the amplifier 1, it is possible to trim the reference voltage for the converter to a higher voltage than the input reference voltage.

The conversion gain of an AD converter decreases when its reference voltage is increased, and increases when its reference voltage is decreased. On the other hand, the conversion gain of a DA converter increases or decreases as its reference voltage is increased or decreased, respectively.

It will be clear that the filters and other parts of the circuits of Fig. 1 are not affected by such adjustment of converter reference voltage, therefore, it is possible to adjust a signal level to a specified value without affecting other circuitry.

By the circuit of Fig. 2, the reference voltage for a converter is varied by trimming circuit 2.

It will be easily understood by those skilled in the art that the converter reference voltage may also be varied by trimming the gain of the amplifier 1. In this case, a trimming circuit may be placed in the feedback circuit $R_1$ and $R_2$.

In summary, if the voltage $V_4$ is used as a reference voltage for an AD or DA converter, the conversion gain can be adjusted by trimming the resistor $R_3$ or $R_4$.

Fig. 3 shows a DA converter utilizing the output (reference) voltage of the circuit of Fig. 2. The circuit of Fig. 3 includes a resistor ladder circuit 5 consisting of n resistors $R_0$ connected in series, n + 1 switches SW connected to each of the connection points of the resistors, being controlled by decoder 4, and buffer amplifier 6.

As shown in Fig. 3, one end of the resistor ladder 5 is grounded and the converter reference voltage $V_{REF}'$ is applied to the other end. The reference voltage $V_{REF}'$ is provided by the output voltage $V_4$ of the circuit in Fig. 2. An input digital signal IN is decoded by the decoder 4, and each of the switches SW is controlled by the decoded signal. As a result, a stepped output signal OUT is provided, corresponding to the input digital signal IN.

This stepped signal is filtered by a low pass filter to provide an analog signal.

For example, if the m-th switch is ON and all other switches are OFF, the output signal voltage OUT is given by the equation:

$$V_{OUT} = \frac{m\, R_0}{nR_0 + r_0}\, V_{REF}' \qquad (3)$$

where $r_0$ is a parasitic resistance of the circuitry. As is evident from equation (3), it is possible to adjust the output voltage OUT to a desired or proper value by adjusting the reference voltage $V_{REF}'$, which is achieved by trimming in the circuit of Fig. 2.

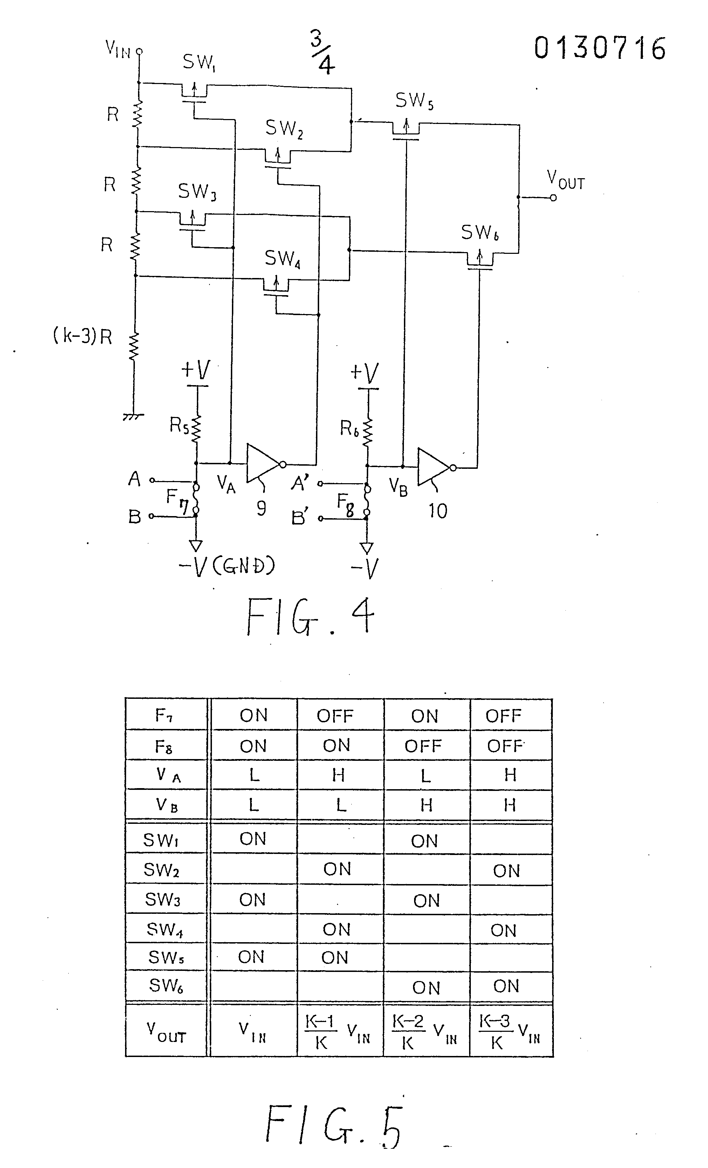

Fig. 4 shows a trimming circuit which can provide four different discrete amounts (modes) of trimming applicable as or in place of the circuit 2 of Fig. 2. In Fig. 4, the circuit includes three resistors R and a resistor (k-3)R connected in series between an input terminal $V_{IN}$ and ground. The circuit includes switches $SW_1 \ldots SW_6$, formed by p-channel MIS (Metal Insulator Semiconductor) transistors, for example, fuses $F_7$, $F_8$, inverters 9, 10, and resistors $R_5$, $R_6$.

In the trimming circuit of Fig. 4, there are first, second and third resistors of resistance R and a fourth resistor of resistance (k-3)R, connected in series. The first resistor is connected to the input terminal $V_{IN}$. In a reference voltage circuit arrangement such as shown in Fig. 2, the terminal $V_{IN}$ is connected to the output of the amplifier 1. The fourth resistor is connected to ground or to a negative voltage source.

The MIS transistor switch $SW_1$ has its source electrode connected to the input terminal $V_{IN}$. The source electrode of switch $SW_2$ is connected to the junction of the first and second resistors, and its drain electrode is connected to the drain electrode of $SW_1$. The source of switch $SW_3$ is connected to the junction of the second and third resistors. The switch $SW_4$ has its source connected to the junction of the third and fourth resistors, and its drain connected to the drain of $SW_3$. Switch $SW_5$ has its source connected to the junction point of the drains of switches $SW_1$ and $SW_2$, and its drain connected to an output terminal $V_{out}$ of the trimming circuit. The switch $SW_6$ has its source connected to the drains of $SW_3$ and $SW_4$, and its drain connected to the output terminal $V_{out}$.

The resistors $R_5$ and $R_6$ are connected to a positive voltage source +V, and the fuses $F_7$ and $F_8$ are connected to a negative voltage source -V. The negative voltage source -V may be replaced by ground. The resistors $R_5$ or $R_6$ and the fuses $F_7$ or $F_8$ are respectively connected in series. The junction point of $R_5$ and $F_7$ is connected to the gate electrodes of MIS transistor switches $SW_1$ and $SW_3$, and to the inverter 9.

The output of the inverter 9 is fed to the gate electrodes of MIS transistors $SW_2$ and $SW_4$.

The junction point of $R_6$ and $F_8$ is connected to the gate electrode of MIS transistor switch $SW_5$, and to the input terminal of the inverter 10. The output of the inverter 10 is fed to the gate electrode of MIS transistor switch $SW_6$. Terminals A, B and A', B' are connected to the ends of fuses $F_7$ and $F_8$ respectively, as shown.

The resistor $(k - 3)R$ is grounded, but in some cases it may be connected to a negative bias voltage source.

The circuit in Fig. 4 is capable of allowing gain adjustment (trimming) between input and output signals in four amounts by blowing out fuse $F_7$ or fuse $F_8$ so as to set the switches in a particular pattern. The fuses are blown by applying a high current at terminals A B or A'B' respectively.

The table of Fig. 5 illustrates the four patterns of trimming.

For example, when the fuses $F_7$ and $F_8$ are both not blown (ON), both inverter input voltages $V_A$ and $V_B$ become low level (L), and the outputs of both inverters 9, and 10, become high level. Therefore the MIS transistors constituting switches $SW_1$, $SW_3$, and $SW_5$ become conductive (ON). Therefore, the input voltage $V_{IN}$ appears at the output terminal $V_{out}$ through the switches $SW_1$ and $SW_5$, and as a result the output voltage $V_{out}$ is equal to the input voltage.

If for example, the fuse $F_7$ is blown (OFF), the input voltage $V_A$ and the output of the inverter 10 are raised to high level, and the input voltage $V_B$ and the output of the inverter 9 are reduced to a low level, so that switches $SW_2$, $SW_4$, and $SW_5$ are set closed (ON). Consequently the input voltage $V_{IN}$ is converted into a voltage $(k - 1) V_{IN}/k$, and this voltage appears at the output terminal through the switches $SW_2$, $SW_5$.

In the circuit of Fig. 4, it is possible to adjust the output voltage in four patterns, that is, four amounts or steps of trimming are possible, as shown in the table in Fig. 5, by selectively blowing off the fuses $F_7$ and $F_8$. Such fuses are conventional ones such as those used in the art of programmable read only memory (PROM), for example. The fuses may be fabricated in the substrate of the IC.

In the circuit of Fig. 4, four steps (amounts) of trimming are possible. But it will be clear to those skilled in the art, that if more steps of trimming are required, it is possible to increase the numbers of series resistances, switches, fuses, and inverters. It is also possible to select the values of the resistors R or $(k - 3)R$ in order to vary the overall range of trimming or the size of the trimming steps.

In the explanation of Fig. 4, the overall circuit arrangement of Fig. 1 or Fig 2, was assumed. As described above, a similar effect can be expected if the trimming circuit of Fig. 4 is inserted in the feedback circuit of amplifier 1, namely $R_1$ and $R_2$ of Fig. 2.

From the standpoint of circuit design, it is desirable to provide contact pads on the semiconductor chip, to allow the application of fuse-blowing signals to terminals A, B, A' and B' in Fig. 4.

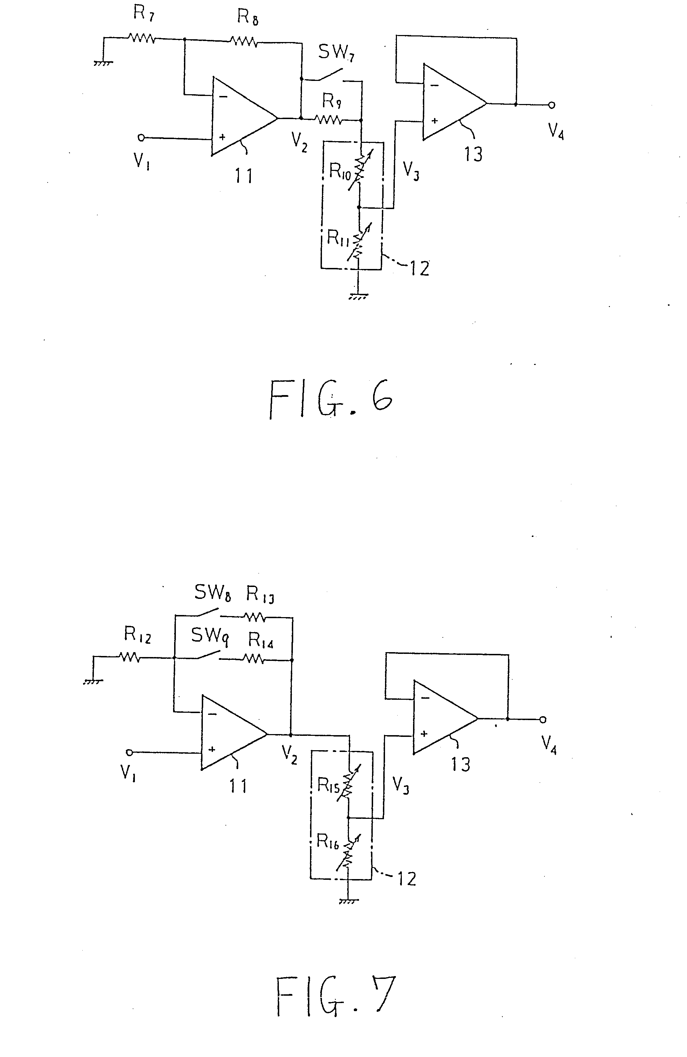

Fig. 6 shows another reference voltage circuit which can be used in an embodiment of the present invention having a function of converter gain adjustment. The circuit of Fig. 6 allows one of two levels of gain to be selected, by switching the converter reference voltage. Such a circuit is useful for a system in which the amplifier characteristics need to be varied, for example, to switch the system from A-law to Mu-law.

In Fig. 6, 11 is an amplifier, 12 is a trimming circuit, and 13 is a buffer amplifier. $R_7$ and $R_8$ are

resistors in a feedback loop of the amplifier 11. $R_{10}$ and $R_{11}$ are resistance values of the trimming circuit 12. These parts correspond with parts 1, 2, 3, $R_1$, $R_2$, $R_3$ and $R_4$ of Figure 2, respectively. In comparison with the circuit of Fig. 2, that of Fig. 6 has an extra resistor $R_9$ and a switch $SW_7$. The resistor $R_9$ and switch $SW_7$ constitute a switched resistor circuit.

The reference voltage circuit of Fig. 6, when the switch $SW_7$ is closed, is equivalent to the circuit of Fig. 2. Therefore, the output voltage $V_4$ can be expressed by equation (4):

$$V_4 = (1 + \frac{R_8}{R_7}) \frac{R_{11}}{R_{10} + R_{11}} V_1 \qquad (4)$$

If the switch $SW_7$ is open, the output voltage $V_4'$ is given by equation (5):

$$V_4' = (1 + \frac{R_8}{R_7}) \frac{R_{11}}{R_9 + R_{10} + R_{11}} V_1 \qquad (5)$$

Therefore, the ratio of the output voltages (that is, the ratio of converter reference voltages) of the circuit when the switch $SW_7$ is closed or open is given as follows:

$$20 \log_{10} \frac{V_4}{V_4'} = 20 \log_{10} (1 + \frac{R_9}{R_{10} + R_{11}}) \qquad (6)$$

The ratio in equation (6) is expressed in power decibel form.

Therefore, if the gain of the converter is required to vary in order to handle signals following different kinds of conversion laws, A-law and Mu-law for example, this can be achieved by switching the reference voltage of the converter. The values of $R_9$, $R_{10}$ and $R_{11}$ should be selected to satisfy equation (6), for the ratio of gains required for A-law and Mu-law.

In other words, the ratio of the gains required for operation under two kinds of conversion laws as described above, is achieved by choosing values of resistors $R_9$, $R_{10}$, and $R_{11}$, in order to satisfy equation (6).

Fig. 7 shows another reference voltage circuit which can be used in an embodiment of the present invention. In this circuit, the gain is adjusted by varying the amount of feedback of the reference voltage amplifier. As shown in Fig. 7, feedback resistors $R_{13}$ and $R_{14}$ are switched by switches $SW_8$ and $SW_9$. In this type of switched resistor circuit, a switch, $SW_8$ or $SW_9$, is connected in series with a resistor, $R_{13}$ or $R_{14}$ respectively.

In Fig. 7, when the switch $SW_8$ is closed and the switch $SW_9$ is opened, the output voltage $V_4$ is given as follows:

$$V_4 = (1 + \frac{R_{13}}{R_{12}}) \frac{R_{16}}{R_{15} + R_{16}} V_1 \qquad (7)$$

When the switch $SW_8$ is open and the switch $SW_9$ is closed, the output voltage $V_4'$ is given as follows:

$$V_4' = (1 + \frac{R_{14}}{R_{12}}) \frac{R_{16}}{R_{15} + R_{16}} V_1 \qquad (8)$$

Therefore, the ratio of the output voltages in these two cases is expressed in power decibel terms as follows:

$$20 \log_{10} \frac{V_4}{V_4'} = 20 \log_{10} \frac{(R_{12} + R_{13})}{R_{12} + R_{14}} \qquad (9)$$

Therefore, in a similar manner as described with respect to equation (6), it is possible to vary the conversion gain of the converter by a factor given by equation (9), by selecting appropriate values of $R_{12}$, $R_{13}$ and $R_{14}$. The shift of conversion gain is performed by setting the switches $SW_8$ and $SW_9$ in Fig. 7.

In Fig. 6 and Fig. 7, the switches may gain be formed by MIS FETs.

As has been described above an embodiment of the present invention provides a circuit including an AD or DA converter, for which the conversion gain can be trimmed. The trimming may be effected by blowing built in fuses. Moreover the present invention provides a circuit including an AD or DA converter, whose conversion gain is switchable. Switchable conversion gain is applicable to a system which handles signals conforming to different kinds of conversion laws.

The disclosure has been made with regard to typical embodiments. Many variations may occur to those skilled in the art. For example, the switches used in the embodiments may be constituted by p-channel FETs or bipolar transistors. The sizes of the trimming steps may be varied to allow rough or fine trimming merely by selecting the resistance values appropriately. In a circuit with switchable conversion gain, the number of levels of gain is not limited to two, it can be easily increased by adding more switches and resistors. It is possible to provide a switched resistor circuit, for switchable conversion gain, without an additional trimming circuit. On the other hand, both a switched resistor circuit and one or more trimming circuits may be incorporated in a feedback loop of the amplifier 1 or 11.

It is possible to provide a switched resistor circuit, for switchable conversion gain, in which the switch or switches are permanently set by blowing fuses, in a similar manner to the trimming circuit of Fig. 4.

On the other hand, it is not necessary for a trimming circuit to incorporate fuses in the manner of the type of trimming circuit shown in Fig. 4. The switches of the trimming circuit could be set non-permanently, to allow trimming to be carried out repeatedly, as required. All such modifications or variations are within the scope of the present invention.

The circuit components used in the above disclosure, such as filters, sample and hold circuits and AD or DA converters, are all well known and conventional, and are fabricated in an IC die or chip. The methods of fabricating such ICs are all well known in the art, and any kind of fabrication method is applicable.

0130716

Claims:

1.	A signal processing integrated circuit comprising an analog to digital converter (AD converter) and /or a digital to analog converter (DA converter) and a reference voltage circuit operable to apply a converter reference voltage to the AD and/or DA converter, comprising

an amplifier arranged for receiving an input reference voltage, and

an adjusting circuit connected to the amplifier, the amplifier and adjusting circuit being operable to determine together the converter reference voltage, so as to allow adjustable conversion gain of the AD and/or DA converter.

2.	An integrated circuit as claimed in claim 1, wherein the adjusting circuit comprises a trimming circuit comprising a voltage divider.

3.	An integrated circuit as claimed in claim 2, wherein said trimming circuit comprises a plurality of resistors connected in series, and switches connected between junction points of the resistors and an output terminal of said trimming circuit,

wherein an output terminal of said amplifier is connected to the output terminal of said trimming circuit through a desired number of the resistors, selected by the setting of the switches.

4.	An integrated circuit as claimed in claim 3, wherein each switch in said trimming circuit is an FET, and is set by blowing a fuse connected between its gate and a voltage source.

5.	An integrated circuit as claimed in claim 2, 3 or 4, wherein said trimming circuit comprises:

a first resistor which is connected to an input terminal of said trimming circuit;

a second resistor which is connected to said first resistor in series;

a third resistor which is connected to said second resistor in series;

a fourth resistor which is connected between said third resistor and ground or between said third resistor and a negative voltage source;

a fifth resistor which is connected to a positive voltage source;

a sixth resistor which is connected to a positive voltage source;

a first p-channel FET (field effect transistor) whose source electrode is connected to said input terminal;

a second p-channel FET whose source electrode is connected to the junction point of said first and second resistors, and whose drain electrode is connected to the drain electrode of said first p-channel FET;

a third p-channel FET whose source electrode is connected to the junction point of said second and third resistors;

a fourth p-channel FET whose source electrode is connected to the junction point of said third and fourth resistors, and whose drain electrode is connected to the drain electrode of said third p-channel FET;

a fifth p-channel FET whose source electrode is connected to the junction point of the drain electrodes of said first and second p-channel FETs, and whose drain electrode is connected to an output terminal of said trimming circuit;

a sixth p-channel FET whose source electrode is connected to the junction point of the drain electrodes of said third and fourth p-channel FETs, and whose drain electrode is connected to said output terminal of said trimming circuit;

a first fuse which is connected between said fifth resistor and a negative voltage source or ground;

a second fuse which is connected between said sixth resistor and a negative voltage source or ground;

a first inverter whose input terminal is connected to the junction point of said first fuse and fifth resistor, and gate electrodes of said first and third p-channel FETs, and whose output terminal is connected to the gate electrodes of said second and fourth p-channel FETs; and

a second inverter whose input terminal is connected to the junction point of said second fuse and sixth resistor, and a gate electrode of said fifth p-channel FET, and whose output terminal is connected to a gate electrode of said sixth p-channel FET.

6. An integrated circuit as claimed in claim 4 or 5, wherein each said fuse is fabricated in a substrate of the integrated circuit.

7. An integrated circuit as claimed in claim 2, or any of claims 3 to 6 when read as appended to claim 2, wherein the adjusting circuit operatively receives and adjusts an output voltage from the amplifier, and an output voltage of the adjusting circuit is used to provide the converter reference voltage.

8. An integrated circuit as claimed in claim 2 or any of claims 3 to 6 read as appended to claim 2, wherein the adjusting circuit is comprised in a feedback loop of the amplifier, being operable to adjust the gain of the amplifier, and an output voltage of the amplifier is used to provide the converter reference voltage.

9. An integrated circuit as claimed in claim 7, wherein the adjusting circuit comprises a switched resistor circuit, comprising a switch and a resistor connected in parallel.

10. An integrated circuit as claimed in claim 8, wherein the adjusting circuit comprises a switched resistor circuit having a plurality of parallel-connected branches, each branch comprising a switch and a resistor connected in series.

11. An integrated circuit as claimed in claim 9, or 10, wherein the switched resistor circuit is operable to select one of at least two values of conversion gain.

12. An integrated circuit as claimed in claim 11, wherein said gain of the integrated circuit is selected as appropriate for processing signals conforming to the A-law or Mu-law conversion law.

13. An integrated circuit as claimed in claim 9, 10, 11 or 12 wherein the or each switch in the switched resistor circuit is an FET.

14. An integrated circuit as claimed in claim 9, or claim 11, 12 or 13 read as appended to claim 9, wherein the trimming circuit and switched resistor circuit are connected in series.

15. An integrated circuit as claimed in any preceding claim, comprising an analog to digital (AD converter) and a digital to analog converter (DA converter) and further comprising

a transmitting filter for filtering undesired frequency components in an input analog signal;

a sample and hold circuit for sampling a signal from the transmitting filter at predetermined time intervals; and

a receiving filter for extracting an analog signal from an output signal of said DA converter.

16. An integrated circuit as claimed in any preceding claim further comprising:

a switch for switching an input terminal of said amplifier of the reference voltage circuit to an external or to an internal input reference voltage source.

FIG. 1

FIG.2

FIG.3

FIG. 4

| | | | | |
|---|---|---|---|---|
| $F_7$ | ON | OFF | ON | OFF |
| $F_8$ | ON | ON | OFF | OFF |
| $V_A$ | L | H | L | H |
| $V_B$ | L | L | H | H |
| $SW_1$ | ON | | ON | |
| $SW_2$ | | ON | | ON |
| $SW_3$ | ON | | ON | |
| $SW_4$ | | ON | | ON |
| $SW_5$ | ON | ON | | |
| $SW_6$ | | | ON | ON |
| $V_{OUT}$ | $V_{IN}$ | $\frac{K-1}{K} V_{IN}$ | $\frac{K-2}{K} V_{IN}$ | $\frac{K-3}{K} V_{IN}$ |

FIG. 5

FIG. 6

FIG. 7